# EUROPEAN PATENT APPLICATION

(11) **EP 2 546 825 A1**
(43) Date of publication of application: **16.01.2013**
(21) Application number: 11837421.4
(22) Date of filing: 15.03.2011
(51) Int. Cl.: G09G 3/36, G06F 13/10

(54) **METHOD, DEVICE AND TERMINAL FOR IDENTIFYING LCD SCREEN**

(30) Priority: 04.11.2010 CN 201010533056
(71) Applicant: ZTE Corporation, Shenzhen, Guangdong 518057 (CN)
(72) Inventor: YANG, Chunni, Guangdong 518057 (CN)
(74) Representative: Manitz, Finsterwald & Partner GbR
(86) International application number: PCT/CN2011/071803
(87) International publication number: WO 2012/058891

(57) **Abstract**

A method, device and terminal for identifying LCD screens can be automatically compatible with a plurality of LCD screens. The device includes a storage module, a voltage regulation module and an identification module. The storage module stores the driver chip parameters of the LCD screens. The voltage regulation module regulates the output voltages of the LCD screens into a processing range of the identification module according to a fixed voltage when accessing to the LCD screens, so as to acquire a regulated voltage. The identification module stores a corresponding relation between the driver chip parameter and the regulated voltage of the corresponding type of LCD screen, and receives a regulated voltage of the voltage regulation module, and then finds the driver chip parameter corresponding to the regulated voltage according to the regulated voltage and the preset corresponding relation.

## Description

### Technical Field

The present invention relates to the field of embedded mobile terminals, and more especially, to a method, device and terminal for identifying liquid crystal display screen.

### Background of the Related Art

With the continuous development of science and technology, more and more embedded products are used in our daily lives, they won the popularity with their compact size and usage convenience, the LCD screen is an essential part in many embedded products and it is the most intuitive impression of this terminal product. The working principle of the LCD screen is that, when the terminal system powers up, the microprocessor first writes the operating parameters corresponding to the driver chip inside the LCD screen into the driver chip, to complete the initialization of the driver chip and ensure that the LCD display screen works properly.

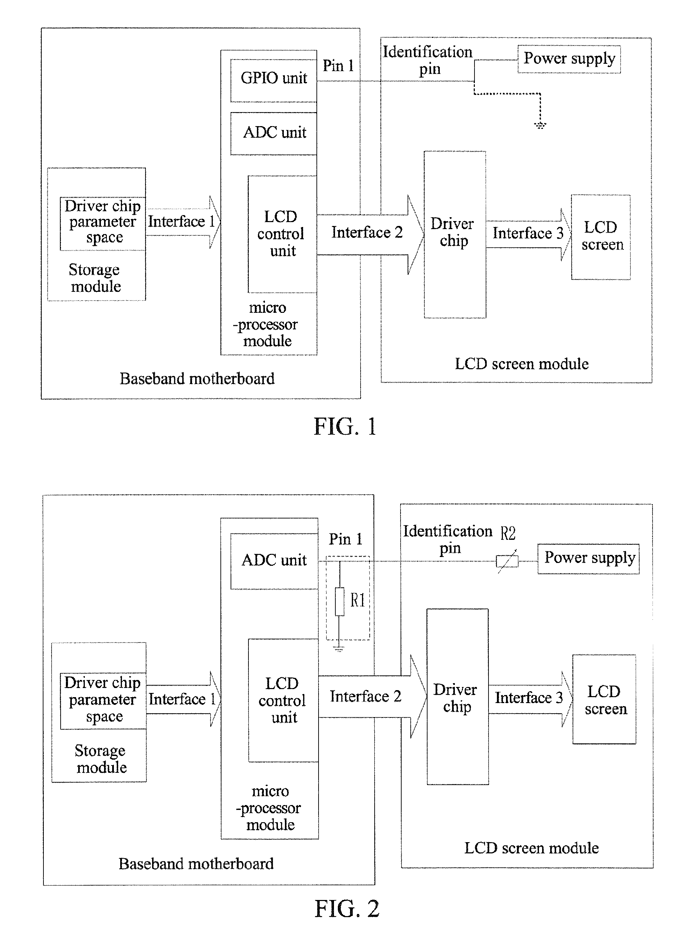

However, with the increasing demand of terminal products, the market of the LCD screen is growing, at the same time, its quality also becomes uneven. If the function of an terminal product is very powerful, however, it is only for the display effect, the display quality of the screen is very poor, it is bound to affect the user experience. At present, the LCD screens from different manufacturers use different driver chips, due to the difference of the driver chips, it is bound to use different drive parameters. At this stage, the LCD display screens of the terminal products we have seen use their corresponding fixed models, if a screen is accidentally damaged, it must be replaced with the same model of display screen from the same manufacturer, although some terminal products can be compatible with different models of LCD screens from two manufacturers, as shown in FIG. 1, it is to determine which model of LCD screen will be used according to the height of a general-purpose input output (GPIO) pin (the identification pin of the LCD is connected to the power supply or the ground), but this approach has certain limitations, since the update rate of the electronic market is very fast, after a few years, maybe these two LCD screens are not produced any more, therefore, the user has to replace it with a new terminal product, which not only affects the user's work but also is a waste of resources.

### Summary of the Invention

The technical problem to be solved in the present invention is to provide a method, device and terminal for identifying liquid crystal display screens to be automatically compatible with a variety of LCD screens.

To solve the aforementioned technical problem, the present invention provides a device for identifying liquid crystal display (LCD) screens, comprising a storage module, a voltage regulation module and an identification module, comprising:
said storage module is set to: save driver chip parameters of the LCD screens;
said voltage regulation module is set to: when accessing to an LCD screen, regulate the output voltage of the LCD screen into a processing range of the identification module according to a fixed voltage to obtain a regulated voltage;
said identification module is set to: save a corresponding relation of the driver chip parameters and the regulated voltage of the corresponding type of LCD screen; and receive the regulated voltage of the voltage regulation module, according to the regulated voltage and the preset corresponding relation, find the driver chip parameters corresponding to the regulated voltage.

Preferably, said device also comprises a parameter transmission module, said parameter transmission module is set to: send the driver chip parameters found by said identification module to the driver chip of said LCD screen.

Preferably, the voltage regulation module comprises a resister and a voltage access terminal accessing to the fixed voltage.

Preferably, the fixed voltage is a ground voltage or a supply voltage.

Preferably, the identification module is an analog-to-digital converter (ADC).

Preferably, the parameter transmission module is a liquid crystal display (LCD) controller.

To solve the aforementioned technical problem, the present invention also provides a terminal that contains the aforementioned device.

To solve the aforementioned technical problem, the present invention also provides a method for identifying LCD screens, comprising:
pre-saving driver chip parameters of one or more types of LCD screens; as well as pre-setting a corresponding relation between the driver chip parameters and the output voltages of corresponding types of LCD screens;
when accessing to an LCD screen, the voltage regulation module regulating the output voltage of the LCD screen into a processing range of the identification module according to a fixed voltage to obtain a regulated voltage; and
the identification module receiving the regulated voltage of the voltage regulation module, and according to the regulated voltage and the pre-set corresponding relation, finding the driver chip parameter corresponding to the regulated voltage.

Preferably, the method also comprises: the parameter transmission module sending the driver chip parameter found by the identification module to the driver chip of said liquid crystal display screen.

Preferably, according to the regulated voltage and the preset corresponding relation, the step of finding the driver chip parameter corresponding to the regulated voltage comprises: converting the regulated voltage of the received analog signal to the regulated voltage of a digital signal, and finding the driver chip parameter corresponding to the regulated voltage according to the regulated voltage of the digital signal as well as the preset corresponding relation.

Compared with the prior art, the method, device and terminal in accordance with the embodiment of the present invention use the analog-to-digital converter (ADC) module built-in the microprocessor as the identification module of the LCD screen, part of the storage space in the storage device of the terminal product works as the parameter storage module of the driver chip of the LCD screen, a variety of different LCD screens can be automatically compatible without adding additional modules and interfaces.

### Brief Description of Drawings

FIG. 1 is a structure diagram of two LCD screens compatible in the prior art;
FIG. 2 is a diagram of a structure compatible with a variety of LCD screens in accordance with a first embodiment of the present invention;
FIG. 3 is a diagram of a structure compatible with a variety of LCD screens in accordance with a second embodiment of the present invention;
FIG. 4 is a flow chart of being compatible with a variety of LCD screens in accordance with a third embodiment of the present invention.

### Preferred Embodiments of the Present Invention

In the following, the embodiments of the present invention will be described in detail with combination of the accompanying drawings. It should be noted that, in the case of no conflict, the embodiments in this application and the characteristics of the embodiments could be combined randomly.

To identify the driver chip parameters of a variety of liquid crystal display screens, the present embodiment provides the following device comprising a storage module, a voltage regulation module and an identification module, wherein:
the storage module saves the driver chip parameters of the liquid crystal display screens; might save the driver chip parameters of a liquid crystal display screen, or save the driver chip parameters of two or more LCD screens.

The voltage regulation module is used to, when accessing to an LCD screen, regulate the output voltage of the liquid crystal display screen according to the fixed voltage into a processing range of the identification module to obtain a regulated voltage;
the identification module is used to save the corresponding relation between the driver chip parameter and the regulated voltage of the corresponding type of LCD screen, receive the regulated voltage of the voltage regulation module, and according to said regulated voltage as well as the preset corresponding relation, find the driver chip parameter corresponding to the regulated voltage.

After the identification module finds the driver chip parameter of the LCD screen, it can identify the LCD screen.

In addition, the device also comprises a parameter transmission module that is used to send the driver chip parameter found by the identification module to the driver chip of said liquid crystal display screen.

In the practical application, the device can be located within the terminal, and the terminal can identify the LCD screen.

### The first embodiment

In the following, the aforementioned device is specifically described with combination of FIG. 2, and this embodiment is mainly used to identify the liquid crystal display screen whose identification pin is connected to the fixed power supply.

The baseband motherboard shown in the FIG. 2 is located within the mobile terminal, comprising a storage module, a voltage regulation module, and a microprocessor module connected with the storage module through the interface 1, wherein:
the storage module is used to store the driver chip parameters, preferably, an existing storage module is used, but it might also be a module dedicated to storing the driver chip parameters. Since a general embedded terminal usually provides a high-capacity storage for the users to use, while the operating parameters of the driver chip of the existing LCD screen module are relatively simple, thus a small part of storage space in the storage module can be set aside to store the operating parameters of the driver chips within a variety of different models of LCD screen modules.

Said voltage regulation module comprises a first resistor (R1 in FIG. 2), and a voltage access terminal accessing to the fixed voltage. In this embodiment, the fixed voltage is the ground voltage. The voltage regulation module regulates the output voltage of the liquid crystal display screen into the processing range of said identification module according to the ground voltage to obtain a regulated voltage;
the microprocessor module comprises an ADC (analog to digital converter) unit and an LCD (Liquid Crystal Display) control unit, wherein:
the ADC unit is the aforementioned identification module, its pin 1 receives the regulated voltage of the voltage regulation module, and the ADC unit is used to convert the regulated voltage of the input analog signal (the analog voltage value) into the regulated voltage of a digital signal, and take the regulated voltage value of the digital signal as the identifier of the model number of the LCD screen module, and find the driver chip parameter corresponding to the regulated voltage according to the regulated voltage. Currently, the ADC unit integrated in the microprocessor has at least eight bits, thus it can provide 256 digital signal values whose range is 0-255, thus theoretically, at least 256 kinds of liquid crystal display modules can be identified.

The LCD control unit is the aforementioned parameter transmission module, and it writes the driver chip parameters into the LCD screen module through the interface 2.

Preferably, the baseband motherboard can use the existing Internet module to regularly update the driver chip parameters to ensure that the driver chip parameters in the storage module are still valid when replacing the LCD screen.

The LCD screen module shown in FIG. 2 is connected to the baseband motherboard, the module comprises a power supply, a second resistor, a driver chip, and an LCD screen; the power supply of the LCD screen module is connected with the second resistor (R2 in the FIG.2), the voltage is output through the identification pin, the driver chip is connected to the LCD screen through the interface 3, wherein:
the power supply is used to work together with said second resistor (R2 in the FIG. 2) to determine the output voltage value of the identification pin;
the driver chip receives the driver chip parameters sent by the baseband motherboard from the interface 2, and drives the LCD screen through the interface 3, when data are displayed, the displayed data are input to the LCD screen through the interface 3;
by setting the second resistor in the LCD screen module as a different resistance, and with the first resistor and the second resistor dividing the voltage, the output voltage of the identification pin can be regulated, that is, the receiving voltage of the ADC unit can be regulated, thus obtaining different digital signal values so that the ADC unit can identify different types of liquid crystal display screens, and then find the corresponding driver chip parameters.

### The second embodiment

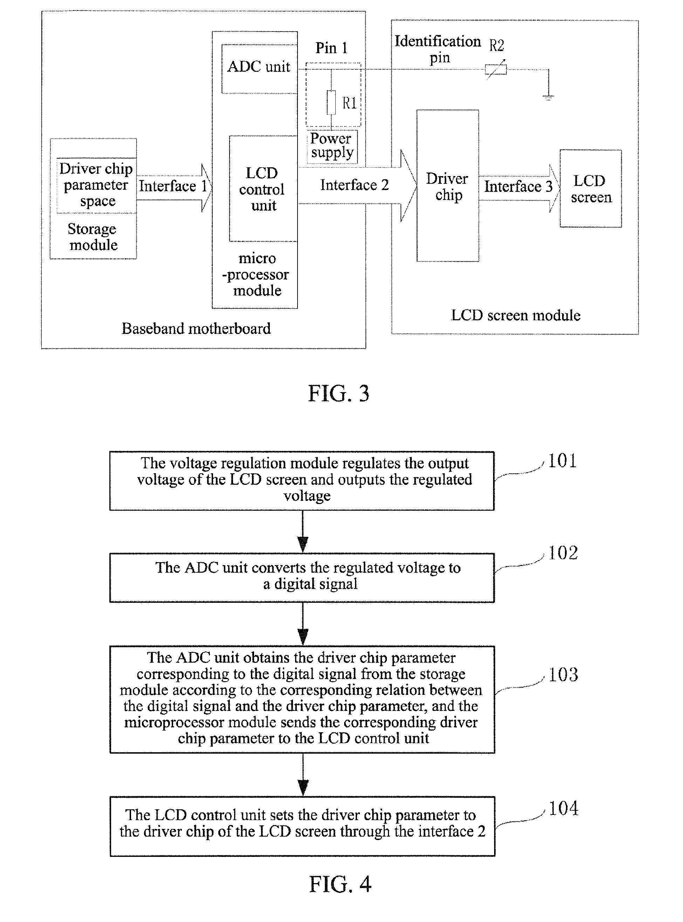

Another method for implementing the aforementioned device will be described in the following with combination of the FIG. 3.

This embodiment is applicable to the LCD screen whose identification pin is connected to the ground. The difference between this embodiment and the embodiment 1 is that the position of the power supply of the LCD screen is connected to the ground, and the fixed voltage accessed by the voltage access terminal in the voltage regulation module of the baseband motherboard is the supply voltage.

Similarly, this embodiment can still achieve the identification of the LCD screen.

### The third embodiment

To achieve the identification of a variety of liquid crystal display screens, this embodiment provides the following method:
pre-saving driver chip parameters of one or more types of LCD screens; as well as pre-setting the corresponding relation between the driver chip parameter and the output voltage of the corresponding type of LCD screen;
when accessing to the LCD screen, the voltage regulation module regulates the output voltage of the LCD screen into the processing range of the identification module according to a fixed voltage to obtain a regulated voltage;
the identification module receiving the regulated voltage of the voltage regulation module, and according to the regulated voltage as well as the pre-set correspondence, finding the driver chip parameter corresponding to the regulated voltage;
the method also comprises: the parameter transmission module sending the driver chip parameter found by the identification module to the driver chip of the liquid crystal display screen.

The aforementioned method will be described in the following with combination of the structure shown in FIG. 2, as shown in FIG. 4, comprising the following steps:
step 101, when accessing to the LCD screen, the voltage regulation module regulates the output voltage of the LCD screen, and outputs the regulated voltage;
step 102, the ADC unit converts the regulated voltage to a digital signal;
step 103, the ADC unit obtains the driver chip parameter corresponding to the digital signal from the storage module according to the corresponding relation between the digital signal and the driver chip parameter, and the microprocessor module sends the corresponding driver chip parameter in the storage module to the LCD control unit through the interface 1;
step 104, the LCD control unit sets the driver chip parameters to the driver chip of the LCD screen through the interface 2 to complete the initialization of the driver chip.

When the data should be displayed via the LCD screen, the microprocessor module sends the data that need to be displayed to the LCD control unit, the LCD control unit sends the displayed data into the driver chip via the interface 2, and the driver chip sends the data to the LCD screen through the interface 3 to display.

With the aforementioned method, there is no need to additionally add a read-only memory for storing the driver program data and the corresponding interface, thus reducing the cost of the LCD screen manufacturers and simplifying the manufacturing process.

The person of ordinary skill in the art can understand that all or part of the steps in the aforementioned method can be implemented by the program instructing the related hardware, the program can be stored in a computer readable storage medium, such as a read-only memory, disk, or CD-ROM. Optionally, all or part of the steps in the above embodiments can be implemented with one or more integrated circuits. Accordingly, each module/unit in the aforementioned embodiments can be implemented in the form of hardware or software functional modules. The present invention is not limited to any particular form of combination of hardware and software.

Of course, the present invention might have a variety of other embodiments, without departing from the spirit and essence of the present invention, the person of ordinary skill in the art can make all kinds of corresponding changes and modifications, and these changes and modifications should belong to the protection scope of the claims appended in the present invention.

For example, besides applying the resistor to regulate the voltage, other voltage regulation device can also be used to regulate the voltage.

### Industrial Applicability

The method, device and terminal in accordance with the embodiment of the present invention use the ADC module built-in the microprocessor as the identification module of the LCD screen, part of the storage space in the storage device of the terminal product works as the parameter storage module of the driver chip of the LCD screen, a variety of different LCD screens can be automatically compatible without adding additional modules and interfaces.

## Claims

1. A device for identifying liquid crystal display (LCD) screens, comprising a storage module, a voltage regulation module and an identification module, wherein:
said storage module is set to: save driver chip parameters of the LCD screens;
said voltage regulation module is set to: when accessing to an LCD screen, regulate an output voltage of the LCD screen into a processing range of the identification module according to a fixed voltage to obtain a regulated voltage;
said identification module is set to: save a corresponding relation between the driver chip parameter and the regulated voltage of a corresponding type of an LCD screen; receive the regulated voltage of the voltage regulation module; and according to the regulated voltage and the preset corresponding relation, find the driver chip parameter corresponding to the regulated voltage.

2. The device of claim 1, wherein, said device also comprises a parameter transmission module, said parameter transmission module is set to: send the driver chip parameter found by said identification module to a driver chip of said LCD screen.

3. The device of claim 1, wherein,
the voltage regulation module comprises a resister and a voltage access terminal accessing to the fixed voltage.

4. The device of claim 1, 2 or 3, wherein,
the fixed voltage is a ground voltage or a supply voltage.

5. The device of claim 1 or 2, wherein,
the identification module is an analog-to-digital converter (ADC).

6. The device of claim 2, wherein,
the parameter transmission module is a liquid crystal display (LCD) controller.

7. A terminal, comprising the device of any one of claims 1~6.

8. A method for identifying LCD screens, comprising:
pre-saving driver chip parameters of one or more types of LCD screens; as well as pre-setting a corresponding relation between the driver chip parameter and an output voltage of a corresponding type of an LCD screen;
when accessing to an LCD screen, the voltage regulation module regulating the output voltage of the LCD screen into a processing range of the identification module according to a fixed voltage to obtain a regulated voltage; and
the identification module receiving the regulated voltage of the voltage regulation module, and finding the driver chip parameter corresponding to the regulated voltage according to the regulated voltage and the pre-set corresponding relation.

9. The method of claim 8, wherein,
the method also comprises: the parameter transmission module sending the driver chip parameter found by the identification module to a driver chip of said liquid crystal display screen.

10. The method of claim 8 or 9, wherein, the step of finding the driver chip parameter corresponding to the regulated voltage according to the regulated voltage and the preset corresponding relation comprises:
converting the received regulated voltage of a analog signal to a regulated voltage of a digital signal, and finding a driver chip parameter corresponding to the regulated voltage according to the regulated voltage of the digital signal as well as the preset corresponding relation.
